# EUROPEAN PATENT APPLICATION

(11) **EP 4 708 360 A1**
(43) Date of publication of application: **11.03.2026**
(21) Application number: 25196309.6
(22) Date of filing: 18.08.2025
(51) Int. Cl.: H01L 23/498, H01L 21/48, H01L 23/538, H01L 23/31, H01L 21/56

(54) **SEMICONDUCTOR DEVICE WITH INTERPOSER AND METHOD THEREFOR**

(30) Priority: 06.09.2024 US 202418826299
(71) Applicant: NXP B.V., 5656 AG Eindhoven (NL)
(72) Inventor: Mao, Kuan-Hsiang, 5656AG Eindhoven (NL); Huang, Wen Hung, 5656AG Eindhoven (NL); Chuang, Wen Yuan, 5656AG Eindhoven (NL); Liu, Yufu, 5656AG Eindhoven (NL); Fang, Che Ming, 5656AG Eindhoven (NL)
(74) Representative: Colaiuda, Antonella

(57) **Abstract**

A method of forming a semiconductor device is provided. The method includes forming an interposer including a plurality of conductive vias, each conductive via having a first end exposed at a first major side of an interposer substrate and a second end exposed at a second major side of the interposer substrate. A semiconductor die is mounted on the first major side of the interposer substrate. An encapsulant encapsulates the semiconductor die and portions of the first major side of the interposer substrate. A redistribution layer structure is formed over the second major side of the interposer substrate such that the semiconductor die interconnected with the redistribution layer structure by way of the interposer.

## Description

### Background

### Field

This disclosure relates generally to semiconductor device packaging, and more specifically, to semiconductor devices with an interposer and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.

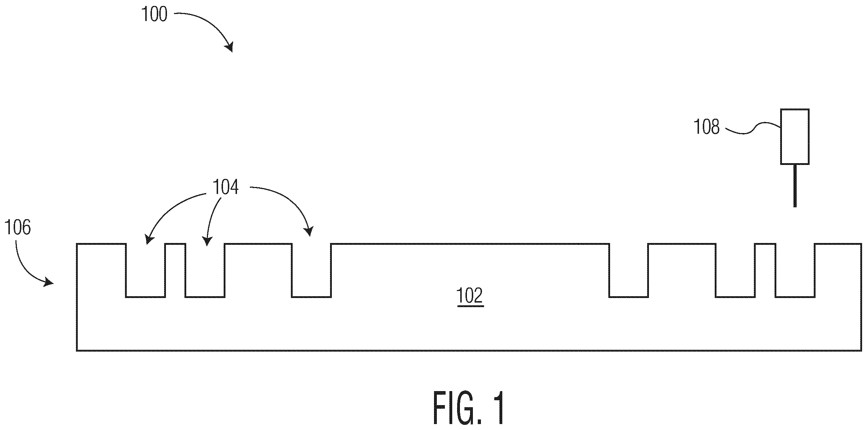

FIG. 1 through FIG. 6 illustrate, in simplified cross-sectional views, an example semiconductor device including an interposer at the stages of manufacture in accordance with an embodiment.

### Detailed Description

Generally, there is provided, a semiconductor device having an interposer. The semiconductor device includes a semiconductor die mounted on the interposer and encapsulated. The interposer is formed from a rigid material (e.g., glass, silicon) which has a coefficient of thermal expansion substantially matched with that of the semiconductor die. A plurality of cavities are formed in the interposer then filled with a conductive material to form a plurality of conductive vias through the interposer. Conductive die connectors connect bond pads of the semiconductor die with the conductive vias at a first side of the interposer. A redistribution layer structure is formed at a second side of the interposer. Conductive features of the redistribution layer substrate are interconnected with the semiconductor die by way of the interposer. Conductive connectors such as solder balls are affixed to exposed trace portions at a bottom side of the redistribution layer structure. By forming the semiconductor device with the interposer in this manner, a substantially thin flip-chip fan-out package with reduced warpage may be realized.

FIG. 1 illustrates, in a simplified top-side-up cross-sectional view, an example semiconductor device 100 having an interposer 106 at a stage of manufacture in accordance with an embodiment. At this stage, the interposer 106 of the semiconductor device 100 includes a non-conductive interposer substrate 102 and a plurality of cavities 104 formed in the interposer substrate. In this embodiment, the interposer substrate 102 is formed from a glass or blank silicon material while in wafer or panel form. By forming the interposer substrate 102 from a glass or blank silicon material, the coefficient of thermal expansion (CTE) property of the interposer substrate 102 may match the CTE property of a semiconductor die mounted on the interposer 106 at a subsequent stage, for example. For illustration purposes, the interposer substrate 102 depicted in FIG. 1 represents one package site from a wafer or panel corresponding to the semiconductor device 100.

In this embodiment, the cavities 104 are formed on a top major side of the interposer substrate 102 by way of laser drilling. The laser drilling may be performed by way of a laser drilling apparatus 108, for example. Alternatively, the cavities 104 may be formed by wet or dry etching. Each cavity 104 is formed to predetermined depth and size dimensions. Each cavity 104 is formed in predetermined locations that correspond to connection sites of one or more components mounted onto the interposer substrate 102 at a subsequent stage, for example. The number, size, shape, and arrangement of the cavities 104 are chosen for illustration purposes.

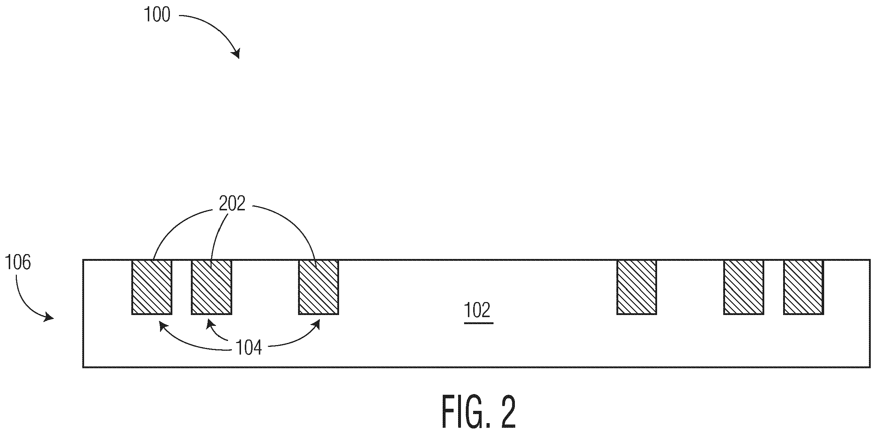

FIG. 2 illustrates, in a simplified top-side-up cross-sectional view, the example semiconductor device 100 at a subsequent stage of manufacture in accordance with an embodiment. At this stage, the interposer 106 of the semiconductor device 100 includes a plurality of conductive vias 202 formed in respective cavities 104. In this embodiment, the conductive vias 202 may be formed by way of an electroplating process or dispensing process. For example, a seed layer (not shown) may be applied in the cavities then electroplated with a copper or other suitable metal to substantially fill the cavities 104 as illustrated. The seed layer may be formed as an alloy or layer combination including a barrier metal, for example. Alternatively, the conductive vias 202 may be formed by electroless deposition or digital printing.

In this embodiment, a first end of the conductive vias 202 is exposed and substantially coplanar with a top side of the interposer substrate 102. The exposed first end of the conductive vias are configured and arranged for interconnection of the one or more components mounted onto the interposer substrate 102 at the subsequent stage, for example. The term "conductive," as used herein, generally refers to electrical conductivity unless otherwise described.

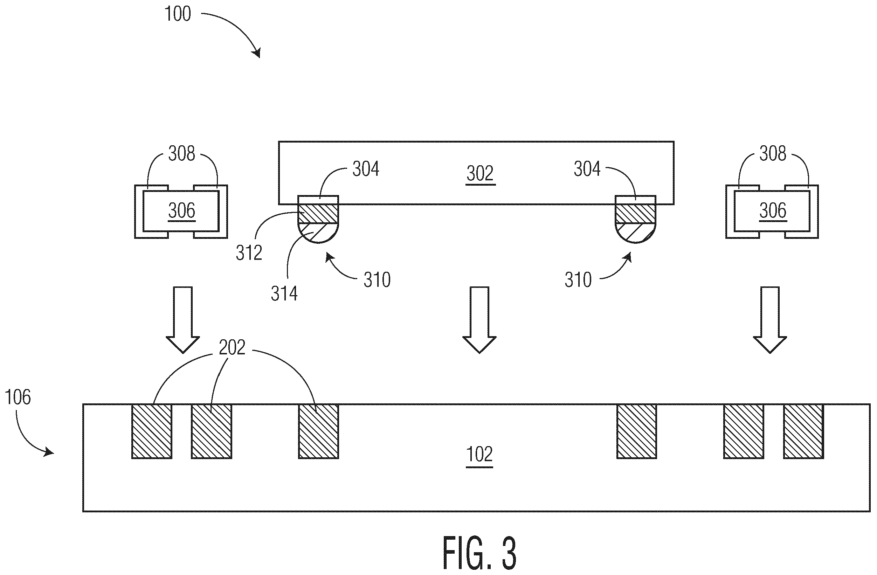

FIG. 3 illustrates, in a simplified top-side-up cross-sectional view, the example semiconductor device 100 at a subsequent stage of manufacture in accordance with an embodiment. At this stage, the semiconductor device 100 includes a semiconductor die 302 and components 306 positioned and aligned over the interposer substrate 102. For example, die connectors 310 affixed to the semiconductor die 302 and terminals 308 of the components 306 are aligned for connection with corresponding conductive vias 202 of the interposer 106.

The semiconductor die 302 has an active side (e.g., major side having circuitry) and a backside (e.g., major side opposite of the active side). The semiconductor die 302 includes bond pads 304 formed at the active side. In this embodiment, semiconductor die 302 is oriented with the active side down having the active side positioned for mounting on the interposer 106. The semiconductor die 302 may be formed from any suitable semiconductor material, such as silicon, germanium, gallium arsenide, gallium nitride, and the like. The semiconductor die 302 further includes any digital circuits, analog circuits, RF circuits, power circuits, sensors, memory, processor, the like, and combinations thereof formed at the active side.

The die connectors 310 are connected to respective bond pads 304 of the semiconductor die 302. The die connectors 310 may be formed as copper pillars, stud bumps, solder balls, and the like, for example. The die connectors 310 may be formed from a suitable conductive material such as gold, copper, aluminum, solder, or alloys thereof. In this embodiment, each of the die connectors 310 is formed as a copper pillar 312 having a solder cap 314. A first end of the copper pillar 312 is formed directly on respective bond pads 304 and the solder cap 314 is formed on a second end of the copper pillar. The solder cap of each die connector 310 is configured to form a conductive bond with a respective conductive via 202 of the interposer 106, for example. The copper pillars 312 and solder caps 314 may be formed by way of electroplating processes, for example. Alternatively, the copper pillars 312 and solder caps 314 may be formed by electroless deposition or digital printing.

The components 306 may be in the form of bare semiconductor die, packaged semiconductor die, sensors, active elements (e.g., transistor, diode), passive elements (e.g., resistor, capacitor, inductor), the like, and combinations thereof. In this embodiment, the components 306 may be characterized as passive elements positioned for mounting on the interposer 106. The terminals 308 of the components 306 are configured to form a conductive bond with a respective conductive via 202 of the interposer 106 by way of a solder paste, for example.

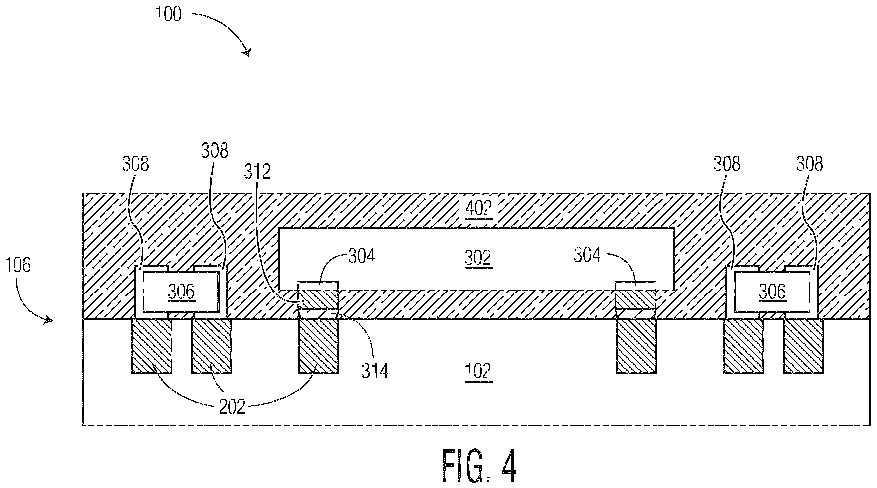

FIG. 4 illustrates, in a simplified top-side-up cross-sectional view, the example semiconductor device 100 at a subsequent stage of manufacture in accordance with an embodiment. At this stage, the semiconductor device 100 includes the semiconductor die 302 and components 306 mounted on the interposer 106 and encapsulated with an encapsulant 402. In this embodiment, the die connectors 310 of the semiconductor die 302 and terminals 308 of the components 306 are conductively connected to conductive vias 202 exposed at the top major side of the interposer substrate 102. In this embodiment, the mounted semiconductor die 302 and components 306 and the top major side of the interposer substrate 102 are over-molded with the encapsulant 402 (e.g., epoxy molding compound) by way of an injection molding or compression molding process, for example.

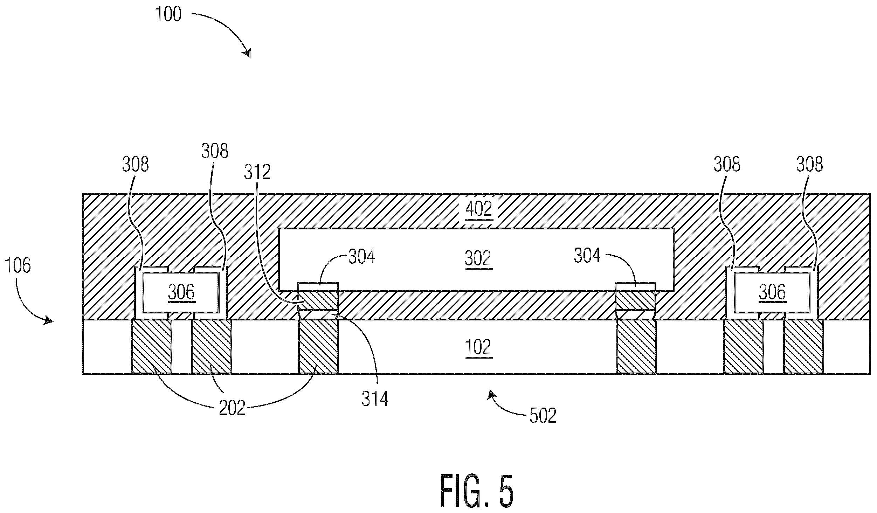

FIG. 5 illustrates, in a simplified top-side-up cross-sectional view, the example semiconductor device 100 at a subsequent stage of manufacture in accordance with an embodiment. At this stage, the semiconductor device 100 includes a second end of the conductive vias 202 revealed at a bottom major side of the interposer 106 of the encapsulated semiconductor device 100. After encapsulating with the encapsulant 402, the bottom major side of the interposer substrate 102 is subjected to a grind operation to expose the second end of the conductive vias 202. The ground side 502 of the interposer substrate 102 exposes the second end of the conductive vias 202 through the interposer substrate 102. The exposed second end of the conductive vias 202 are configured and arranged for interconnection of a redistribution layer (RDL) structure 608 applied at a subsequent stage, for example. By forming the interposer 106 in this manner, a rigid and thin interposer having a matched CTE may be realized.

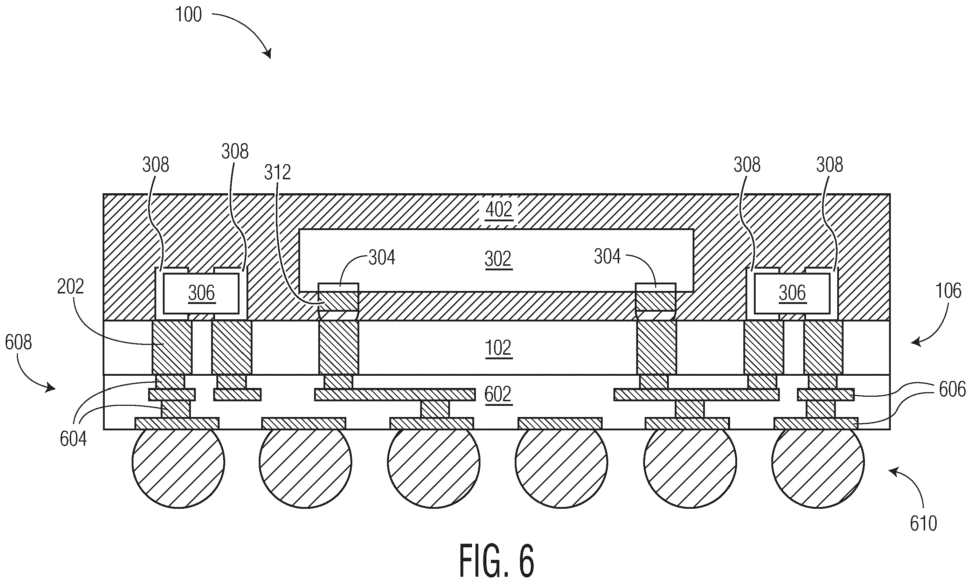

FIG. 6 illustrates, in a simplified top-side-up cross-sectional view, the example semiconductor device 100 at a subsequent stage of manufacture in accordance with an embodiment. At this stage, the semiconductor device 100 includes an RDL structure 608 applied to the bottom major side of the interposer 106 of the encapsulated semiconductor device 100. The RDL structure 608 is conductively connected to the second ends of the conductive vias 202 exposed at the bottom major side of the interposer substrate 102, for example.

The RDL structure 608 includes conductive features such as vias 604 and traces 606 surrounded by non-conductive material (e.g., dielectric) 602. In this embodiment, the conductive traces 606 are formed from patterned metal (e.g., copper) layers separated by dielectric layers (602) of the RDL structure 608. Portions of the traces 606 are exposed at a bottom side of the RDL structure 608 and serve as conductive connector pads configured for attachment of conductive connectors 610, for example. The vias 604 and traces 606 are formed in the RDL structure 608 to interconnect the semiconductor die 302 (by way of the interposer 106) with a printed circuit board (PCB), for example. The RDL structure 608 may be formed as a build-up substrate directly on the second major side of the interposer substrate 102 or may be provided as a pre-formed structure otherwise applied on the second major side of the interposer substrate 102.

In this embodiment, conductive connectors 610 (e.g., solder balls) are affixed to respective traces 606 exposed at the bottom side of the RDL structure 608. The conductive connectors 610 may be in the form of suitable conductive structures such as solder balls, gold studs, copper pillars, and the like, to connect conductive features of the semiconductor device 100 with the PCB.

Generally, there is provided, a method including forming an interposer including a plurality of conductive vias, each conductive via having a first end exposed at a first major side of an interposer substrate and a second end exposed at a second major side of the interposer substrate; mounting a semiconductor die on the first major side of the interposer substrate; encapsulating with an encapsulant the semiconductor die and portions of the first major side of the interposer substrate; and forming a redistribution layer (RDL) structure over the second major side of the interposer substrate, the semiconductor die interconnected with the RDL structure by way of the interposer. The forming the interposer may further include grinding the second major side of the interposer substrate to expose the second end of each conductive via at the second major side first of the interposer substrate. The semiconductor die may include a plurality of die connectors formed on respective bond pads of the semiconductor die, the bond pads interconnected with the plurality of conductive vias by way of the plurality of die connectors. The each of die connectors may be formed as a copper pillar having a solder cap, the solder cap of each die connector forming a conductive bond with a respective conductive via. The forming the interposer may further include forming a plurality of cavities in the first major side of the interposer substrate; and electroplating a conductive material in each cavity of the plurality of cavities to form the plurality of conductive vias. The plurality of cavities may be formed by way of laser drilling. The interposer substrate of the interposer may be formed from a glass wafer or a silicon wafer. The method may further include mounting a passive component on the first major side of the interposer substrate before encapsulating with the encapsulant. The method may further include affixing a plurality of conductive ball connectors to respective exposed pads of the RDL structure.

In another embodiment, there is provided, a semiconductor device including an interposer including: an interposer substrate, and a plurality of conductive vias formed through the interposer substrate, a first end of each conductive via exposed at a first major side of the interposer substrate and a second end of each conductive via exposed at a second major side of the interposer; a semiconductor die mounted on the first major side of the interposer substrate; an encapsulant encapsulating the semiconductor die and portions of the first major side of the interposer substrate; and a redistribution layer (RDL) structure formed over the second major side of the interposer substrate, the semiconductor die interconnected with the RDL structure by way of the interposer. The semiconductor die may include a plurality of die connectors formed on respective bond pads of the semiconductor die, the plurality of bond pads interconnected with the plurality of conductive vias by way of the plurality of die connectors. The each of die connectors may be formed as a copper pillar having a solder cap, the solder cap of each die connector configured to form a conductive bond with a respective conductive via. The conductive vias may be formed from a copper or copper alloy material. The interposer substrate of the interposer may be formed from a glass wafer or a silicon wafer. The semiconductor device may further include a plurality of conductive ball connectors affixed to respective pads of the RDL structure.

In yet another embodiment, there is provided, a method including forming an interposer including: an interposer substrate, a plurality of cavities formed in a first major side of the interposer substrate, and a conductive via formed in each cavity of the plurality of cavities, a first end of the conductive via exposed at the first major side of the interposer substrate; mounting a semiconductor die on the first major side first major side of the interposer substrate, the semiconductor die including a plurality of bond pads; encapsulating with an encapsulant the semiconductor die and portions of the first major side of the interposer substrate; grinding a second major side of the interposer substrate to expose a second end of each conductive via at the second major side first of the interposer substrate; and forming a redistribution layer (RDL) structure over the second major side of the interposer substrate, the semiconductor die interconnected with the RDL structure by way of the interposer. The semiconductor die may include a plurality of die connectors formed on respective bond pads of the semiconductor die, the plurality of bond pads interconnected with the plurality of conductive vias by way of the plurality of die connectors. The plurality of cavities formed in a first major side of the interposer substrate may be formed by way of laser drilling. The conductive vias may be formed by way of electroplating a conductive material in each cavity of the plurality of cavities. The interposer substrate of the interposer may be formed from a glass wafer or a silicon wafer.

By now, it should be appreciated that there has been provided a semiconductor device having an interposer. The semiconductor device includes a semiconductor die mounted on the interposer and encapsulated. The interposer is formed from a rigid material which has a coefficient of thermal expansion matched with that of the semiconductor die. A plurality of cavities are formed in the interposer then filled with a conductive material to form a plurality of conductive vias through the interposer. Conductive die connectors connect bond pads of the semiconductor die with the conductive vias at a first side of the interposer. A redistribution layer structure is formed at a second side of the interposer. Conductive features of the redistribution layer substrate are interconnected with the semiconductor die by way of the interposer. Conductive connectors such as solder balls are affixed to exposed trace portions at a bottom side of the redistribution layer structure. By forming the semiconductor device with the interposer in this manner, a substantially thin flip-chip fan-out package with reduced warpage may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming an interposer including a plurality of conductive vias, each conductive via having a first end exposed at a first major side of an interposer substrate and a second end exposed at a second major side of the interposer substrate;
mounting a semiconductor die on the first major side of the interposer substrate;
encapsulating with an encapsulant the semiconductor die and portions of the first major side of the interposer substrate; and
forming a redistribution layer (RDL) structure over the second major side of the interposer substrate, the semiconductor die interconnected with the RDL structure by way of the interposer.

2. The method of claim 1, wherein the forming the interposer further includes grinding the second major side of the interposer substrate to expose the second end of each conductive via at the second major side first of the interposer substrate.

3. The method of claim 1 or claim 2, wherein the semiconductor die includes a plurality of die connectors formed on respective bond pads of the semiconductor die, the bond pads interconnected with the plurality of conductive vias by way of the plurality of die connectors.

4. The method of claim 3, wherein the each of die connectors is formed as a copper pillar having a solder cap, the solder cap of each die connector forming a conductive bond with a respective conductive via.

5. The method according to any preceding claimwherein the forming the interposer further includes:
forming a plurality of cavities in the first major side of the interposer substrate; and
electroplating a conductive material in each cavity of the plurality of cavities to form the plurality of conductive vias.

6. The method of claim 5, wherein the plurality of cavities are formed by way of laser drilling.

7. The method according to any preceding claim, wherein the interposer substrate of the interposer is formed from a glass wafer or a silicon wafer.

8. The method according to any preceding claim, further comprising mounting a passive component on the first major side of the interposer substrate before encapsulating with the encapsulant.

9. The method according to any preceding claim, further comprising affixing a plurality of conductive ball connectors to respective exposed pads of the RDL structure.

10. A semiconductor device comprising:
an interposer including:
an interposer substrate, and
a plurality of conductive vias formed through the interposer substrate, a first end of each conductive via exposed at a first major side of the interposer substrate and a second end of each conductive via exposed at a second major side of the interposer;
a semiconductor die mounted on the first major side of the interposer substrate;
an encapsulant encapsulating the semiconductor die and portions of the first major side of the interposer substrate; and
a redistribution layer (RDL) structure formed over the second major side of the interposer substrate, the semiconductor die interconnected with the RDL structure by way of the interposer.

11. The semiconductor device of claim 10, wherein the semiconductor die includes a plurality of die connectors formed on respective bond pads of the semiconductor die, the plurality of bond pads interconnected with the plurality of conductive vias by way of the plurality of die connectors.

12. The semiconductor device of claim 11, wherein the each of die connectors is formed as a copper pillar having a solder cap, the solder cap of each die connector configured to form a conductive bond with a respective conductive via.

13. The semiconductor device according to claims 10 to 12, wherein the conductive vias are formed from a copper or copper alloy material.

14. The semiconductor device according to claims 10 to 13, wherein the interposer substrate of the interposer is formed from a glass wafer or a silicon wafer.

15. The semiconductor device according to claims 10 to 14, further comprising a plurality of conductive ball connectors affixed to respective pads of the RDL structure.
